# EUROPÄISCHE PATENTSCHRIFT

(11) **EP 3 738 134 B1**
(45) Veröffentlichungstag und Bekanntmachung des Hinweises auf die Patenterteilung: **23.04.2025**
(21) Anmeldenummer: 19707275.4
(22) Anmeldetag: 11.02.2019
(51) Int. Cl.: H01F 27/12, H01F 27/36, H01F 27/40, H05K 9/00, H01L 23/60, H01L 23/06, H01L 25/07

(54) **VORRICHTUNG ZUM ABSCHIRMEN EINES LEISTUNGSHALBLEITERS IN EINEM MIT EINEM ISOLIERFLUID BEFÜLLTEN KESSEL**
DEVICE FOR SHIELDING A POWER SEMICONDUCTOR IN A TANK FILLED WITH AN INSULATING FLUID
DISPOSITIF DE BLINDAGE D'UN SEMI-CONDUCTEUR DE PUISSANCE DANS UNE CUVE REMPLIE D'UN FLUIDE ISOLANT

(30) Priorität: 07.03.2018 DE 102018203425
(43) Veröffentlichungstag der Anmeldung: 18.11.2020
(73) Patentinhaber: Siemens Energy Global GmbH & Co. KG, 81739 München (DE)
(72) Erfinder: FRITSCHE, Ronny, 90469 Nürnberg (DE); METH, Jochen, 91448 Emskirchen (DE); VELKOV, Vassil, 91452 Wilhermsdorf (DE)
(86) Internationale Anmeldenummer: PCT/EP2019/053288
(87) Internationale Veröffentlichungsnummer: WO 2019/170372

(56) Entgegenhaltungen:
- DE-A1- 102016 203 106
- DE-C- 402 723

## Beschreibung

Die Erfindung betrifft eine Vorrichtung zum Abschirmen eines Leistungshalbleiters in einem mit einem Isolierfluid befüllten Kessel, wobei die Vorrichtung folgende Merkmale aufweist:
- ein Elektrodengehäuse mit elektrisch leitfähigen Elektrodenwandungen, die einen zur Aufnahme des Leistungshalbleiters eingerichteten Elektrodeninnenraum von allen Seiten begrenzend kapseln, wobei das Elektrodengehäuse mehrere Gehäusemodule aufweist, wobei jedes Gehäusemodul zur Aufnahme eines Leistungshalbleiters eingerichtet ist, und
- eine Barrierenanordnung, die wenigstens eine Barriere aus einem nichtleitenden Material aufweist, wobei die Barrierenanordnung das Elektrodengehäuse von allen Seiten umschließt.

Aus der DE 10 2016 203106 A1 ist eine Vorrichtung zum Abschirmen von Leistungshalbleitern bekannt, wobei die Leistungshalbleiter auf einem Hochspannungspotential liegen. Die vorbekannte Vorrichtung verfügt über mehrere Abschirmvorrichtungen, die durch im Wesentlichen zur Rechteckform gebogene Rohre gegeben sind. Die Rohre bestehen zumindest teilweise aus Metall und bilden eine Art Käfig um die abzuschirmenden Leistungshalbleiter.

Die DE 402723 offenbart eine Isolation für Hochspannung führende Wicklungen von Transformatoren.

Dem Fachmann ist aus der ständigen Praxis bekannt, Abschirmelektroden einzusetzen, um Spannungsspitzen an Ecken und Kanten von Komponenten zu vermeiden, die auf einem Hochspannungspotenzial liegen. Vorbekannte Abschirmelektroden sind aus einem elektrisch leitenden Material gefertigt, so dass diese für das elektrische Feld eine Equipotenziallinie bilden. Der Einsatz von Abschirmelektroden in einem mit Isolierfluid befüllten Kessel ist jedoch aufwändig.

Neben dem Einsatz von Abschirmelektroden können hohe elektrische Feldstärken durch eine zweckmäßige Ausgestaltung der Bauelemente vermieden werden. So kann das Bauelement beispielsweise ohne scharfe Kanten oder Ecken gefertigt werden. Leistungshalbleiter, wie beispielsweise Dioden, Thyristoren, GTOs, IGBTs oder IGCTs sind zwar am Markt erhältlich, weisen jedoch insbesondere im Hinblick auf ihre Elektronik Ecken und Kanten auf. Daher müssen die Abstände zwischen einem Leistungshalbleiter auf einem Hochspannungspotenzial und einem benachbarten elektrischen Bauelement oder umgebenden Kesselelementen ausreichend groß sein, um hohe elektrische Feldstärken sicher anschließen zu können.

Den vorbekannten Lösungen haftet der Nachteil an, dass das Einhalten der geforderten Abstände zu einem raumgreifenden Kessel führt. Dies erhöht die Kosten und das Gewicht des Kessels.

Aufgabe der Erfindung ist es daher, eine Vorrichtung der eingangs genannten Art zu schaffen, die einen kompakten Kesselbau ermöglicht und gleichzeitig Spannungsspitzen an Bauelementen im Kessel aufgrund hoher Feldstärken sicher vermeidet.

Diese Aufgabe wird im Rahmen der Erfindung durch eine Vorrichtung gemäß Anspruch 1 gelöst.

Die erfindungsgemäße Vorrichtung dient zur Abschirmung von Leistungshalbleitern, wie beispielsweise Leistungshalbleiterschaltern oder Leistungshalbleiterdioden, die während des Betriebs auf einem Hochspannungspotenzial liegen. Die Leistungshalbleiter sind im Rahmen der Erfindung in einem Kessel angeordnet, in dem auch andere Bauteile angeordnet sind, die ebenfalls auf einem Hochspannungspotenzial liegen. Der Kessel ist hingegen im Rahmen der Erfindung geerdet. Um hohe Spannungsspitzen an den Leistungshalbleitern beim Betrieb zu vermeiden, ist ein Elektrodengehäuse vorgesehen, das über Elektrodenwandungen verfügt. Die Elektrodenwandungen weisen ein elektrisch leitfähiges Material auf und begrenzen von allen Seiten einen Elektrodeninnenraum, so dass dieser vollständig gekapselt ist. Mit allen Seiten ist hier gemeint, dass der Elektrodeninnenraum vorne, hinten, rechts, links, oben und unten von den Elektrodenwandungen begrenzt ist. Ein in dem Elektrodengehäuse angeordneter Leistungshalbleiter befindet sich daher, zumindest bei einer angelegten Wechselspannung, in einem so genannten Faradayschen Käfig, also in einem feldfreien Raum. Auf diese Weise werden Spannungsspitzen an Ecken oder Kanten des Leistungshalbleiterschalters einschließlich seiner Elektronik vermieden.

Der Kessel ist bevorzugt der Kessel eines Transformators, der mit einem Isolierfluid befüllt ist und in dem ein Aktivteil angeordnet ist. Das Aktivteil weist einen Kern mit konzentrisch zueinander angeordneten Wicklungen auf, die einen Abschnitt des Kerns umschließen. Die Wicklungen sind über Anschlussleitungen jeweils mit einem Innenleiter einer Hochspannungsdurchführung verbunden, die an ihrem vom Kessel abgewandten Ende einen Freiluftanschluss zum Anschluss einer Hochspannungsleitung aufweist.

Um den Kessel noch kompakter ausgestalten zu können, ist das Elektrodengehäuse im Rahmen der Erfindung von einer Barrierenanordnung umgeben, die wenigstens eine Barriere aus einem elektrisch nichtleitenden Material aufweist. Die Barrierenanordnung umgibt das Elektrodengehäuse vollständig und ermöglicht eine noch kompaktere Bauweise des Kessels und des gesamten elektrischen Geräts, welches den Kessel umfasst. Dabei ermöglicht die Barrierenanordnung den Durchtritt von Isolierfluid zum Elektrodengehäuse. Das Elektrodengehäuse ist ebenfalls undicht ausgestaltet. Mit anderen Worten kann das Isolierfluid des Kessels durch die Barrierenanordnung und die Elektrodenwandung in den Elektrodeninnenraum dringen, um dort die notwendige Spannungsfestigkeit und Kühlung der Leistungshalbleiter bereitzustellen.

Gemäß einer bevorzugten Ausgestaltung der Erfindung sind benachbart angeordnete Elektrodenwandungen zur Vermeidung von Kreisströmen mit Abstand zueinander angeordnet und begrenzen Trennstellen zwischen sich. Treten in dem Kessel beim Betrieb hohe magnetische Felder auf, die von elektrischen Wechsel-oder Gleichströmen erzeugt werden, können bei geschlossenen umlaufenden Gehäusen unerwünschte Kreisströme gebildet werden, die für hohe Verluste sorgen können. Aus diesem Grunde verfügt das Elektrodengehäuse über wenigstens eine Trennstelle, die zwischen einander gegenüber und somit benachbart liegenden Elektrodenwandungen ausgebildet ist beziehungsweise sind. Zur Ausbildung einer Trennstelle sind benachbarte Elektrodenwandungen mit einem Abstand zueinander angeordnet. Dieser Abstand ist klein genug, um einen feldfreien Elektrodeninnenraum zu gewährleisten. Er ist jedoch so groß, dass ein Stromfluss zwischen den Elektrodenwandungen sicher unterbrochen ist.

Erfindungsgemäß sind die Elektrodenwandungen abschnittsweise flach oder mit anderen Worten plattenförmig ausgestaltet, wobei deren Kanten abgerundet sind. Durch die abgerundeten Kanten sind scharfe Ecken oder Kanten im Rahmen der Erfindung vermieden, die beim Betrieb für hohe Feldstärken und somit Spannungsspitzen sorgen können. Die plattenförmige Ausgestaltung der Elektrodenwandung erleichtert das Ausbilden des gekapselten Elektrodengehäuses und ist darüber hinaus kostengünstig.

Gemäß einer bevorzugten Ausgestaltung sind die Elektrodenwandungen an ihrer vom Elektrodeninnenraum abgewandten Seite mit einem Isolierstoff beschichtet. Die Beschichtung unterstützt das Unterdrücken der hohen Feldstärken, so dass der Kessel und das zugehörige elektrische Gerät noch kompakter ausgestaltet werden können. Die Elektrodenwandungen umfassen gemäß dieser vorteilhaften Weiterentwicklung einen metallischen Grundkörper und eine Beschichtung aus Isolierstoff. Der Isolierstoff kann beispielsweise ein Isolierpapier auf natürlicher oder synthetischer Basis sein. Die Isolierschicht kann auch durch Nassumformung aufgebracht oder mit anderen Worten gegautscht werden. Selbstverständlich ist es Rahmen der Erfindung auch möglich, die Elektrodenwandungen auch auf ihrer Innenseite mit einer Isolierschicht auszurüsten.

Erfindungsgemäß verfügt das Elektrodengehäuse über mehrere Gehäusemodule, wobei jedes Gehäusemodul zur Aufnahme eines Leistungshalbleiters eingerichtet ist. Gemäß dieser vorteilhaften Weiterentwicklung der Erfindung ist berücksichtigt, dass in dem Kessel, beispielsweise zur Regelung der Ausgangsspannung eines Transformators oder zur Umwandlung von Gleichspannung in Wechselspannung mehrere Leistungshalbleiter, also Leistungshalbleiterschalter oder Leistungshalbleiterdioden oder beides, einschließlich der notwendigen Elektronik erforderlich sind. Dazu bildet das Elektrodengehäuse eine den jeweiligen Anforderungen entsprechende Anzahl von Gehäusemodulen aus. Jedes Gehäusemodul ist zur Aufnahme eines Leistungshalbleiters eingerichtet.

Gemäß einer weiteren Ausgestaltung der Erfindung umfassen die Elektrodenwandungen Elektrodenseitwandungen, die ein jeweils zugeordnetes Gehäusemodul umfänglich umschließen und die in einer Draufsicht U-förmig oder L-förmig oder I-förmig ausgebildete Elektrodenseitenwandungsteile umfassen, die zwischen sich eine Trennstelle begrenzen.

Vorteilhafterweise verfügt jedes Gehäusemodul über wenigstens eine Anlenkstelle zur elektrischen Verbindung mit dem aufgenommenen Leistungshalbleiter.

Zweckmäßigerweise sind die Elektrodenmodule übereinander angeordnet. Das Aufstapeln der Elektrodenmodule zu einem Elektrodengehäuse mit übereinander angeordneten Modulen hat sich als besonders zweckmäßig herausgestellt, um zu einer kompakten Bauweise für das elektrische Gerät einschließlich des besagten Kessels zu gelangen.

Gemäß einer bevorzugten Ausgestaltung kapselt jedes Gehäusemodul den aufgenommenen Leistungshalbleiter vollumfänglich. Mit anderen Worten bilden die Elektrodenwandungen seitlich gekapselte Gehäusemodule aus, die jeweils zur Aufnahme eines Leistungshalbleiters eingerichtet sind. Das Elektrodengehäuse ist gemäß dieser vorteilhaften Weiterentwicklung aus den miteinander verbundenen Untergehäusen zusammengesetzt, wobei jedes Untergehäuse oder Gehäusemodul einen Modulinnenraum ausbildet, der wenigstens umfänglich, also vorne, hinten, rechts und links, von Elektrodenwandungen begrenzt ist. Sind die Gehäusemodule übereinander angeordnet, verfügt das oberste Gehäusemodul zusätzlich über einen Elektrodendeckel und das unterste Gehäusemodul über einen Elektrodenboden, so dass eine vollständige Kapselung durch das Elektrodengehäuse ermöglicht ist.

Die Gehäusemodule bilden vorteilhafterweise einen gemeinsamen Elektrodeninnenraum aus, in dem zwei oder mehrere Leistungshalbleiter angeordnet sind. Nach außen sind die Leistungshalbleiter aufgrund der gekapselten Bauweise des Elektrodengehäuses als Ganzes vollständig gekapselt.

Gemäß einer bevorzugten Ausgestaltung sind die Gehäusemodule elektrisch isoliert voneinander gehalten. Die Elektrodenwandungen, durch welche die Gehäusemodule definiert sind, also die Elektrodenseitenwandungen sind dazu vorteilhafterweise mit Abstand zueinander angeordnet. Dies ist beispielsweise durch eine isolierte Halterung ermöglicht. Es ist jedoch auch möglich, elektrisch nichtleitende Abstandshalter aus Isolierstoff einzusetzen. Die Gehäusemodule sind zweckmäßigerweise mit Abstand zueinander angeordnet, so dass zwischen ihnen eine Trennstelle ausgebildet ist.

Gemäß einer bevorzugten Ausgestaltung der Erfindung umfasst die Barrierenanordnung mehrere Barrieren, die mit Abstand zueinander angeordnet sind und eine Labyrinthstruktur ausbilden. Die Barrierenanordnung ist für einen Einsatz in einem mit Isolierfluid gefüllten Kessel vorgesehen. Das Isolierfluid ist beispielsweise ein mineralisches Öl oder eine Esterflüssigkeit, die beim Betrieb der erfindungsgemäßen Vorrichtung zwischen den Barrieren der Barrierenanordnung angeordnet ist. Dabei unterstützt das Isolierfluid die Isolierung der Leistungshalbleiter im Inneren der erfindungsgemäßen Vorrichtung. Die Labyrinthstruktur ermöglicht den Ein- und Austritt des Isolierfluids durch die Barrieren der Barrierenanordnung.

Die Barrierenanordnung besteht im Rahmen der Erfindung aus einem beliebigen Isolierstoff. Vorteilhafterweise besteht die Barrierenanordnung und jede Barriere der Barrierenanordnung jedoch aus Pressspan. Pressspan oder ein vergleichbarer Zellulosestoff hat sich zur Isolierung von Bauteilen mit Isolierfluid befüllten Kesseln als vorteilhaft herausgestellt.

Gemäß einer bevorzugten Ausgestaltung der Erfindung ist jede Barriere aus einem oder mehreren Winkelringen und einer oder mehreren plattenförmigen Barrierenwandungen zusammengesetzt.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleichwirkende Bauteile verweisen und wobei
- Figur 1: Leistungshalbleiter in einer perspektivischen Ansicht,
- Figur 2: ein Ausführungsbeispiel der erfindungsgemäßen Vorrichtung in einer perspektivischen Ansicht,
- Figur 3: ein Gehäusemodul der Vorrichtung gemäß Figur 2 in einer Draufsicht,
- Figur 4: ein weiteres Ausführungsbeispiel eines Gehäusemoduls in einer Draufsicht,
- Figur 5: zwei benachbarte Elektrodenwandungen in einer geschnitten Ansicht,
- Figur 6: ein Ausführungsbeispiel der erfindungsgemäßen Vorrichtung in einer geschnitten Stirnansicht und
- Figur 7: ein weiteres Ausführungsbeispiel eines Gehäusemoduls einer Draufsicht verdeutlichen.

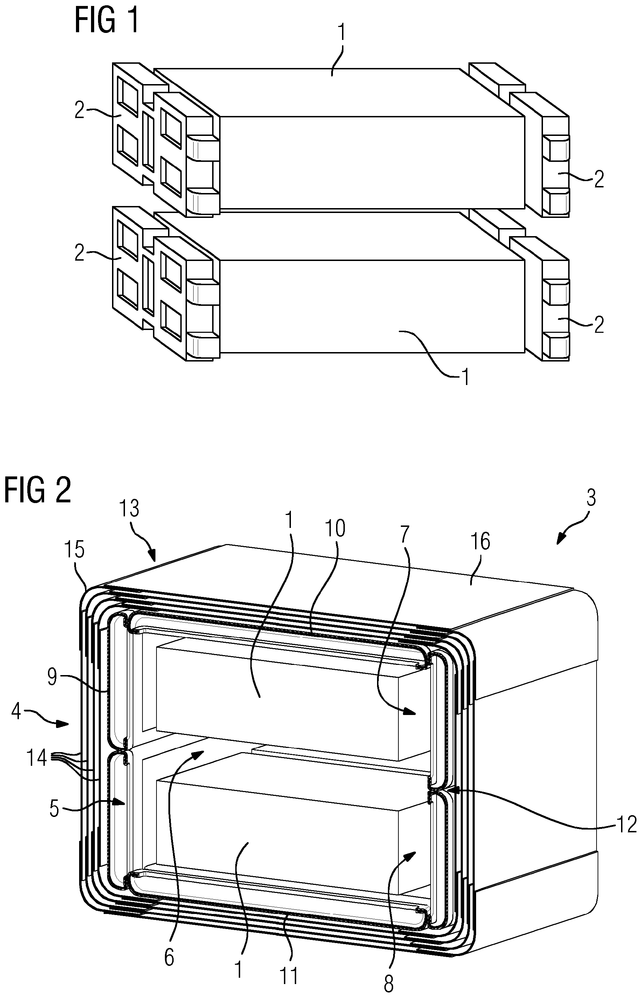

Figur 1 zeigt schematisch ein Ausführungsbeispiel zweier Leistungshalbleiter 1, die für einen Betrieb in einem mit einem Isolierfluid befüllten Kessel eines elektrischen Geräts eingerichtet sind. Die gezeigten Leistungshalbleiter 1 umfassen an jeder Seite ein Trägermodul 2, das zur Montage einer figürlich nicht dargestellten Elektronik dient, die ebenfalls Teil des Leistungshalbleiters 1 ist. Der Leistungshalbleiter 1 ist beispielsweise eine Diode, ein Thyristor oder ein selbstgeführter Leistungshalbleiterschalter, wie beispielsweise ein GTO, ein IGBT, ein IGCT oder dergleichen.

Der mit Isolierfluid befüllte Kessel ist beispielsweise Teil eines Transformators oder einer Drossel, der oder die zum Anschluss an ein Hochspannungsnetz eingerichtet ist. Aufgrund der zum Teil sehr hohen Betriebs- und Prüfspannungen entstehen innerhalb des besagten Kessels hohe elektrische Feldstärken, vor allem an den Ecken und Kanten des Leistungshalbleiters 1. Um Spannungsüberschläge innerhalb des Kessels und einen sicheren Betrieb des Leistungshalbleiters 1 zu ermöglichen und darüber hinaus den Kessel weiterhin kompakt ausgestalten zu können, wird im Rahmen der Erfindung jeder Leistungshalbleiter 1 abgeschirmt.

Figur 2 zeigt ein Ausführungsbeispiel der erfindungsgemäßen Vorrichtung 3, die zur Abschirmung der Leistungshalbleiter 1 gemäß Figur 1 dient. Die Vorrichtung 3 umfasst ein Elektrodengehäuse 4, das über elektrisch leitfähige Elektrodenwandungen 5 verfügt, die aus einem elektrisch leitfähigen Material bestehen. Dabei begrenzen die Elektrodenwandungen 5 einen Elektrodeninnenraum 6, der in zwei Gehäusemodule 7 und 8 unterteilt ist. Jedes Gehäusemodul 7, 8 verfügt über Elektrodenseitenwandungen 9, die jedes Gehäusemodul 7 beziehungsweise 8 umfänglich umgeben. Das Gehäusemodul 7 ist nach oben durch eine Elektrodendeckelwandung 10 und das Gehäusemodul 8 durch eine Elektrodenbodenwandung 11 nach unten begrenzt. Zwischenböden zwischen den Gehäusemodulen 7, 8, sind in dem gezeigten Ausführungsbeispiel nicht vorgesehen.

Es ist in dem in Figur 2 gezeigten Schnitt erkennbar, dass jede Elektrodenwandung 5 einen flächigen Wandabschnitt sowie beidseitig abgerundete Ecken ausbilden, um hohe Feldstärken an diesen zu vermeiden. Dabei sind die Elektrodenwandungen 5 aus einem elektrisch leitfähigen Material, beispielsweise einem Metall, wie Aluminium, gefertigt, wobei sie an ihrer vom Elektrodeninnenraum 6 abgewandten Seite mit einer Isolierschicht, hier einem Nassumformstoff, also aufgegautschtes Papier, beschichtet sind. Darüber hinaus sind die Elektrodenwandungen 5 des Gehäusemoduls 6 und die Elektrodenwandungen 5 des Gehäusemoduls 8 mit Abstand zueinander gehalten, so dass zwischen den besagten Elektrodenwandungen 5 eine Trennstelle 12 erkennbar ist. Der Abstand zwischen den Elektrodenwandungen 5 liegt im Bereich zwischen 0,5 und 10 cm, so dass eine ausreichende elektrische Isolierung, gleichzeitig aber auch eine gewünschte vollständige Kapselung der Leistungshalbleiter 1 geschaffen ist.

Die Vorrichtung 3 weist darüber hinaus eine Barrierenanordnung 13 auf, die mehrere mit Abstand zueinander angeordnete Barrieren 14 aufweist. Jede Barriere besteht aus ringförmigen Winkelringen 15 sowie aus flächigen Barrierewandungen 16, deren Enden mit den Enden der Winkelringe 15 überlappen. Im Überlappungsbereich sind diese jedoch mit Abstand zu den Winkelringen 15 gehalten, so dass ein labyrinthartiges System geschaffen ist, durch welche Isolierfluid in den Zwischenraum gelangen kann, der von einander zugewandten Barrieren 14 begrenzt wird. Darüber hinaus gelangt das Isolierfluid über die Trennstellen 12 in den Elektrodeninnenraum 6 zur Kühlung und Isolierung der dort angeordneten Leistungshalbleiter 1. Dabei umschließt die Barrierenanordnung 13 das Elektrodengehäuse 4 vollständig.

Zum Halten der Barrierewandungen 16 und der Winkelringe 15 der jeweiligen Barriere 14 sowie der gesamten Barrierenanordnung 13 dienen figürlich nicht dargestellte Abstandshalter, Abstandsklötze oder Abstandsleisten, die, wie die gesamte Barrierenanordnung 13, aus einem elektrisch nichtleitenden Material und insbesondere aus Pressspan gefertigt sind.

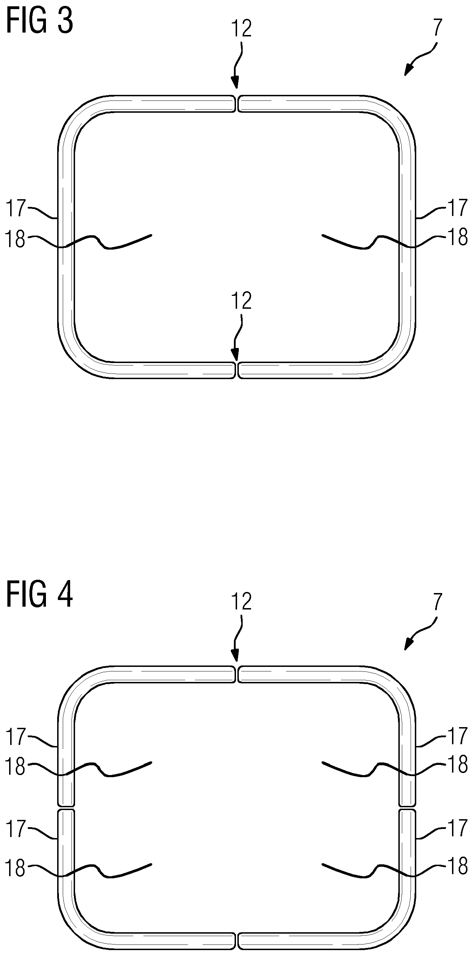

Figur 3 zeigt die Elektrodenseitenwandungen 9 des Gehäusemoduls 7, ohne die Elektrodendeckelwandung und Elektrodenbodenwandung in einer Draufsicht. Es ist erkennbar, dass die Elektrodenseitenwandung 9 aus zwei in der Draufsicht U-förmigen Elektrodenseitenwandteilen 17 besteht, zwischen denen ebenfalls Trennstellen 12 ausgebildet sind. Die Elektrodenseitenwandteile 17 sind dabei in der Draufsicht U-förmig ausgebildet, wobei jedes Elektrodenseitenwandteil 17 mit einer Potenzialanlenkstelle 18 ausgerüstet ist, um die metallisch leitenden Abschnitte des jeweiligen Elektrodenseitenwandteils 17 mit dem in dem jeweiligen Gehäusemodul 7, 8 angeordneten Leistungshalbleiter 1 elektrisch zu verbinden, so dass der Leistungshalbleiter 1 und alle Elektrodenseitenwandteile 17 auf dem gleichen Potenzial liegen.

Figur 4 zeigt ein von Figur 3 abweichendes Ausführungsbeispiel der Elektrodenseitenwandteile 17, die in einer Draufsicht jeweils L-förmig ausgebildet sind, so dass vier Elektrodenseitenwandteile 17 notwendig sind, um das Gehäusemodul 7 vollumfänglich zu umschließen. Somit ergeben sich vier Trennstellen 12. Jedes Elektrodenseitenwandteil 17 verfügt wieder über eine Potenzialanlenkstelle 18.

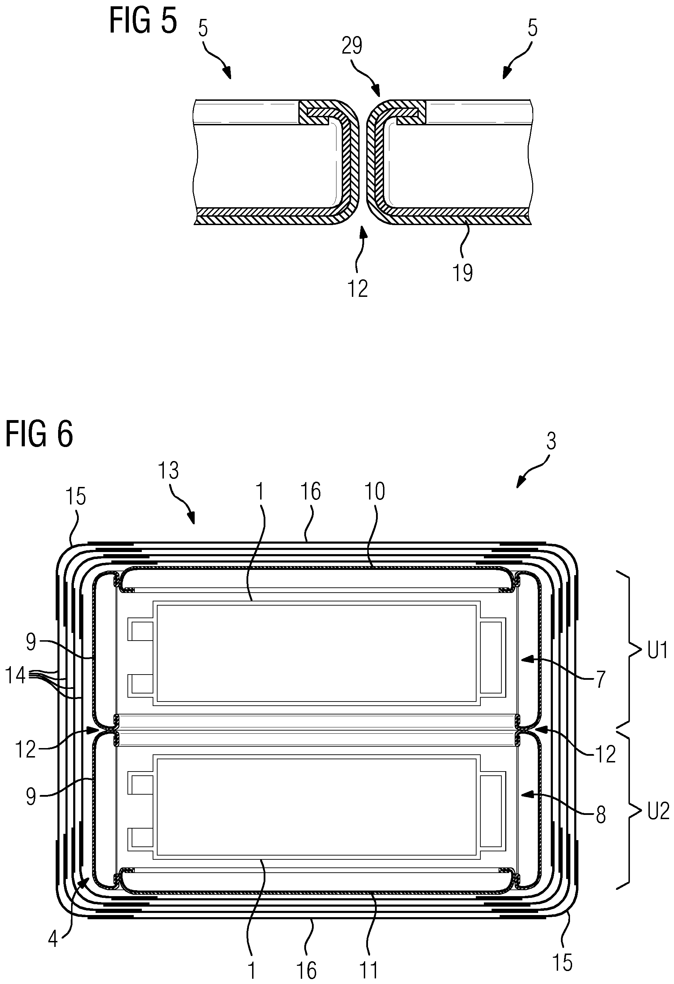

Figur 5 verdeutlich schematisch den Aufbau einer beispielhaften Elektrodenwandung 5 genauer, insbesondere verdeutlicht Figur 5, dass die Elektrodenwandungen 5 mit Abstand zueinander angeordnet sind und eine Trennstelle 12 begrenzen. Ferner ist erkennbar, dass jede Elektrodenwandung 5 aus einem metallischen Material gefertigt ist, das außen, also an der von dem Elektrodeninnenraum abgewandten Seite der Elektrodenwandung 5 mit einem Isolierstoff 19 beschichtet ist. Darüber hinaus sind die Kanten und Ecken 20 der jeweiligen Elektrodenwandung 5 abgerundet ausgeführt, um hohe Spannungsspitzen oder Feldstärken zu vermeiden.

Figur 6 zeigt die Vorrichtung 3 gemäß Figur 2 in einer Stirnansicht. Insbesondere ist hier genauer erkennbar, dass das Gehäusemodul 7 und das Gehäusemodul 8 elektrisch isoliert voneinander gehalten sind, so dass zwischen ihnen eine Trennstelle 12 ausgebildet ist. Dies ermöglicht die Aufnahme von Leistungshalbleitern 1, die unterschiedliche Potenziale aufweisen. Im gezeigten Beispiel weist der obere Leistungshalbleiter 1 ein Potenzial U1 auf, wohingegen der untere Leistungshalbleiter ein Potenzial von U2 aufweist. Dies gilt entsprechend für die Elektrodenwandungen 5, die das jeweilige Gehäusemodul 7, 8 umschließen.

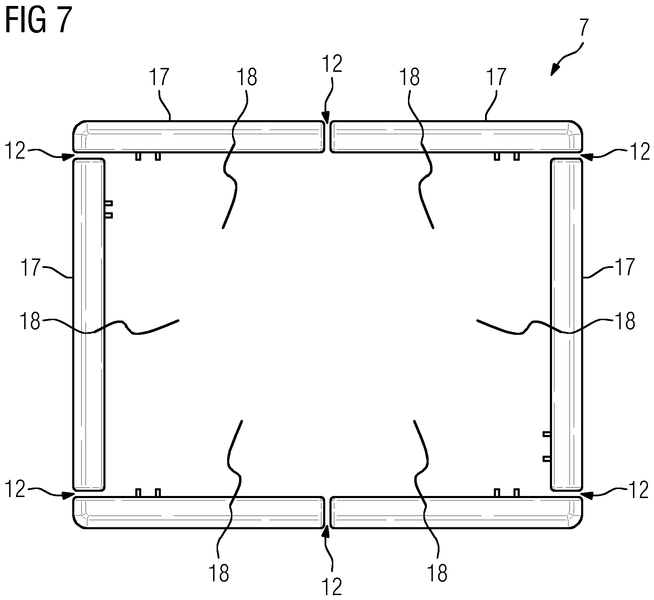

Figur 7 zeigt ein weiteres Ausführungsbeispiel der Elektrodenseitenwandung 9 in einer Darstellung gemäß Figur 3 oder 4. Es ist erkennbar, dass jedes Elektrodenseitenwandteil 17 in der gezeigten Draufsicht I-förmig ausgebildet ist, sich also nur in einer Längsrichtung erstreckt. Wieder wird von den einander zugewandten Elektrodenseitenwandungsteilen 18 eine Trennstelle 12 begrenzt.

## Patentansprüche

1. Vorrichtung (3) zur Abschirmung eines mit Hochspannung beaufschlagbaren Leistungshalbleiters (1) in einem mit einem Isolierfluid befüllten Kessel, wobei die Vorrichtung (3) folgende Merkmale aufweist:
- ein Elektrodengehäuse (4) mit elektrisch leitfähigen Elektrodenwandungen (5), die einen zur Aufnahme des Leistungshalbleiters (1) eingerichteten Elektrodeninnenraum (6) von allen Seiten begrenzend kapseln, wobei das Elektrodengehäuse (4) mehrere Gehäusemodule (7,8) aufweist, wobei jedes Gehäusemodul (7,8) zur Aufnahme eines Leistungshalbleiters (1) eingerichtet ist, und
- eine Barrierenanordnung (13), die wenigstens eine Barriere (14) aus einem nichtleitenden Material aufweist, wobei
die Barrierenanordnung (13) das Elektrodengehäuse (4) von allen Seiten umschließt, **dadurch gekennzeich net,** dass
die Elektrodenwandungen (5) abschnittsweise plattenförmig ausgestaltet sind, wobei deren Kanten abgerundet sind.

2. Vorrichtung (3) nach Anspruch 1,
**dadurch gekennzeichnet, dass**
benachbarte Elektrodenwandungen (5) zur Vermeidung von Kreisströmen mit Abstand zueinander angeordnet sind und zwischen sich eine Trennstelle (12) begrenzen.

3. Vorrichtung (3) nach einem der vorhergehenden Ansprüche,
**dadurch gekennzeichnet , dass**
die Elektrodenwandungen (5) an ihrer vom Elektrodeninnenraum (6) abgewandten Seite mit einem Isolierstoff (19) beschichtet sind.

4. Vorrichtung (3) nach einem der vorhergehenden Ansprüche,
**dadurch gekennzeichnet , dass**
Elektrodenwandungen (5) Elektrodenseitwandungen (9) umfassen, die ein jeweils zugeordnetes Gehäusemodul (7,8)umfänglich umschließen und die in einer Draufsicht U-förmig, L-förmig oder I-förmig ausgebildete Elektrodenseitenwandungsteile (17) umfassen, die zwischen sich eine Trennstelle (12) begrenzen.

5. Vorrichtung (3) nach einem der vorhergehenden Ansprüche,
**dadurch gekennzeichnet , dass**
jedes Gehäusemodul (7,8) wenigstens eine Anlenkstelle (18) zur elektrischen Verbindung mit dem aufgenommenen Leistungshalbleiter aufweist.

6. Vorrichtung (3) nach einem der vorhergehenden Ansprüche,
**dadurch gekennzeichnet , dass**
jedes Gehäusemodul (7,8) den aufgenommenen Leistungshalbleiter (1) vollständig kapselt.

7. Vorrichtung (3) nach einem der vorhergehenden Ansprüche,
**dadurch gekennzeichnet , dass**
die Gehäusemodule (7,8) gegeneinander elektrisch isoliert gehalten sind.

8. Vorrichtung (3) nach einem der vorhergehenden Ansprüche,
**dadurch gekennzeichnet , dass**
die Barrierenanordnung (13) mehrere Barrieren (14) aufweist, die mit Abstand zueinander angeordnet sind und eine Labyrinthstruktur ausbilden, die den Eintritt von Isolierfluid in die Barrierenanordnung (13) ermöglicht.

9. Vorrichtung (3) nach Anspruch 8,
**dadurch gekennzeichnet, dass**
jede Barriere Winkelringe (15) und plattenförmige Barrierenwandungen (16) aufweist.

## Claims

1. Device (3) for shielding a power semiconductor (1) that can be subjected to high voltage in a tank filled with an insulating fluid, wherein the device (3) has the following features:
- an electrode housing (4) with electrically conductive electrode walls (5) which encapsulate an electrode interior space (6) configured to receive the power semiconductor (1) from all sides in a limiting manner, wherein the electrode housing (4) comprises multiple housing modules (7, 8), wherein each housing module is configured to receive a power semiconductor (1), and
- a barrier arrangement (13) that comprises at least one barrier (14) made of a non-conductive material, wherein the barrier arrangement (13) encloses the electrode housing (4) from all sides,
**characterized in that** the electrode walls (5) are configured to be plate-shaped in sections, wherein their edges are rounded.

2. Device (3) according to Claim 1,
**characterized in that** adjacent electrode walls (5) are arranged spaced apart from one another to prevent circulating currents and a define separation point (12) between them.

3. Device (3) according to any one of the preceding claims,
**characterized in that** the electrode walls (5) are coated on their side facing away from the electrode interior space (6) with an insulating material (19).

4. Device (3) according to any one of the preceding claims,
**characterized in that** the electrode walls (5) comprise electrode side walls (9) that fully enclose a housing module (7, 8) assigned in each case and comprise electrode side wall parts which are U-shaped, L-shaped or I-shaped electrode side wall parts 17 in plan view and define a separation point (12) between them.

5. Device (3) according to any one of the preceding claims,
**characterized in that** each housing module (7, 8) has at least one connection point (18) for electrical connection to the received power semiconductor (1).

6. Device (3) according to any one of the preceding claims,
**characterized in that** each housing module (7, 8) fully encapsulates the received power semiconductor (1).

7. Device (3) according to any one of the preceding claims,
**characterized in that** the housing modules (7, 8) are electrically insulated from one another.

8. Device (3) according to any one of the preceding claims,
**characterized in that** the barrier arrangement (13) comprises multiple barriers (14) that are arranged spaced apart from one another and form a labyrinth structure, allowing the entry of insulating fluid into the barrier arrangement (13).

9. Device (3) according to Claim 8,
**characterized in that** each barrier is composed of angle rings (15) and plate-shaped barrier walls (16).

## Revendications

1. Dispositif (3) de blindage d'un semiconducteur (1) de puissance pouvant être alimenté par la haute tension, dans une cuve remplie d'un fluide isolant, dans lequel le dispositif (3) a les caractéristiques suivantes :
- un boîtier (4) formant électrode ayant des parois (5) d'électrode conductrices de l'électricité, qui blindent en le limitant de tous les côtés un espace (6) intérieur d'électrode conçu pour la réception du semiconducteur (1) de puissance, dans lequel le boîtier (4) formant électrode a plusieurs modules (7, 8) de boîtier, dans lequel chaque module (7, 8) de boîtier est conçu pour la réception d'un semiconducteur (1) de puissance, et
- un agencement (13) à barrières, qui a au moins une barrière (14) en un matériau non conducteur, dans lequel l'agencement (13) à barrières entoure le boîtier (4) formant électrode de tous les côtés, **caractérisé en ce que**
les parois (5) d'électrode sont conformées par partie sous forme de plaque, dont les arêtes sont arrondies.

2. Dispositif (3) suivant la revendication 1,
**caractérisé en ce que**
des parois (5) d'électrode voisines sont disposées à distance l'une de l'autre pour empêcher des courants circulaires et délimitent entre elles un point (12) de coupure.

3. Dispositif (3) suivant l'une des revendications précédentes,
**caractérisé en ce que**
les parois (5) d'électrode sont revêtues d'une substance (19) isolante sur leurs faces non tournées vers l'espace (6) intérieur d'électrode.

4. Dispositif (3) suivant l'une des revendications précédentes,
**caractérisé en ce que**
les parois (5) d'électrode comprennent des parois (9) latérales d'électrode, qui enferment sur le pourtour un module (7, 8) de boîtier associé respectivement et qui comprennent des parties (17) de parois latérales d'électrode constituées en vue en plan en forme de U, en forme de L ou en forme de I, qui délimitent entre elles un point (12) de coupure.

5. Dispositif (3) suivant l'une des revendications précédentes,
**caractérisé en ce que**
chaque module (7, 8) de boîtier a au moins un point (18) d'articulation pour la connexion électrique avec le semiconducteur de puissance reçu.

6. Dispositif (3) suivant l'une des revendications précédentes,
**caractérisé en ce que** chaque module (7, 8) blinde complètement le semiconducteur (1) de puissance reçu.

7. Dispositif (3) suivant l'une des revendications précédentes,
**caractérisé en ce que**
les modules (7, 8) du boîtier sont maintenus isolés électriquement les uns par rapport aux autres.

8. Dispositif (3) suivant l'une des revendications précédentes,
**caractérisé en ce que**
l'agencement (13) à barrières a plusieurs barrières (14), qui sont disposées à distance les unes des autres et qui forment une structure en labyrinthe, qui rend possible une entrée de fluide isolant dans l'agencement (13) à barrières.

9. Dispositif (3) suivant la revendication 8,
**caractérisé en ce que**
chaque barrière a des cornières (15) annulaires et des parois (16) de barrières en forme de plaque.
